# EUROPÄISCHE PATENTANMELDUNG

(11) **EP 2 538 465 A1**
(43) Veröffentlichungstag der Anmeldung: **26.12.2012**
(21) Anmeldenummer: 11170550.5
(22) Anmeldetag: 20.06.2011
(51) Int. Cl.: H01L 41/09, H01Q 1/38, H01Q 3/44, H01Q 9/04

(54) **Leiteranordnung**

(71) Anmelder: Bayer MaterialScience AG, 51373 Leverkusen (DE)
(72) Erfinder: Die Erfindernennung liegt noch nicht vor

(57) **Zusammenfassung**

Die Erfindung betrifft eine Leiteranordnung (2,2.1,2.2), umfassend mindestens einen an einem Substrat (4) angebrachten elektrisch leitfähigen Leiter (12,12.1,12.2), wobei der elektrisch leitfähige Leiter (12,12.1,12.2) eine vorgebbare geometrische Struktur aufweist, wobei das Substrat (4) mindestens eine zwischen einer ersten Elektrode (6,6.1) und mindestens einer zweiten Elektrode (8,8.1) angeordnete elektroaktive Schicht (10,10.1) aufweist und der elektrisch leitfähige Leiter (12,12.1,12.2) an dem Substrat (4) angebracht ist, derart, dass die geometrische Struktur des elektrisch leitfähigen Leiters (12,12.1,12.2) in Abhängigkeit eines zwischen der ersten Elektrode (6,6.1) und der zweiten Elektrode (8,8.1) anlegbaren elektrischen Steuersignals änderbar ist.

## Beschreibung

Die Erfindung betrifft eine Leiteranordnung umfassend mindestens einen an einem Substrat angebrachten elektrisch leitfähigen Leiter, wobei der elektrisch leitfähige Leiter eine vorgebbare geometrische Struktur aufweist. Darüber hinaus betrifft die Leiteranordnung eine Vorrichtung umfassend diese Leiteranordnung, ein Kommunikationsgerät umfassend diese Vorrichtung und ein Verfahren zur Herstellung einer Leiteranordnung.

Bei Antennenanordnungen des Stands der Technik, aber auch bei anderen Leiteranordnungen, welche zumindest einen auf einem Substrat angeordneten elektrisch leitfähigen Leiter aufweisen, hängen wesentliche Eigenschaften der Antennenanordnung bzw. der Leiteranordnung unter anderem von der geometrischen Struktur des elektrisch leitfähigen Leiters ab. Die geometrische Struktur eines Leiters wird im Allgemeinen durch eine Mehrzahl von geometrischen Parametern, wie Breite, Länge, Höhe, Verlauf, z.B. geradlinig, spiralförmig, gekrümmt, sich verjüngend, sich erweiternd, etc. bestimmt sein. Diese geometrischen Parameter können die Leitereigenschaften bzw. Antenneneigenschaften, wie die Sende- oder Empfangsfrequenz, die Güte und dergleichen, beeinflussen.

Um zum Beispiel eine Antennenanordnung zur Verfügung zu stellen, welche für eine Vielzahl von unterschiedlichen Sende- oder Empfangsfrequenzen verwendet werden kann, ist es bekannt, ein Antennenarray mit einer entsprechenden Mehrzahl an Antennen bereitzustellen. Insbesondere wird für jede Sende- oder Empfangsfrequenz eine geometrisch angepasste Antenne bereitgestellt. Nachteilig hieran ist jedoch zum einen, dass eine Vielzahl unterschiedlicher Antennen mit einem entsprechenden Raumbedarf bereitgestellt werden müssen, deren Ansteuerung zudem komplex ist. Zum anderen muss bei der Herstellung der Antennen bereits die spätere Anwendung bekannt sein, da eine nachträgliche Anpassung der geometrischen Struktur der Antenne, beispielsweise eine Abstimmung auf andere Sende- oder Empfangsfrequenzen, kaum möglich ist.

In der WO 01/31714 A1 wird eine Membran-Position-Steuerung beschrieben. Gemäß diesem Stand der Technik kann eine als Antenne einsetzbare Membran mittels einer Vielzahl an Verbindungselementen aufgespannt werden. Hierbei sind die Verbindungselemente als Aktuatoren ausgebildet, um in Abhängigkeit einer elektrischen Aktivierung der Aktuatoren die Position der Membran zu verändern. Nachteilig an diesem Stand der Technik sind der komplexe Aufbau und die schwierige Steuerung der Vorrichtung. Ferner sind die Einstell- und Änderungsmöglichkeiten bei der Positionierung der Membran beschränkt.

Daher liegt der vorliegenden Erfindung die Aufgabe zugrunde, eine Leiteranordnung zur Verfügung zu stellen, welche in einfacher Weise die Änderung von mindestens einer Leitereigenschaft ermöglicht.

Die zuvor hergeleitete und aufgezeigte Aufgabe wird gemäß einem ersten Aspekt der Erfindung bei einer Leiteranordnung umfassend mindestens einen an einem Substrat angebrachten elektrisch leitfähigen Leiter, wobei der elektrisch leitfähige Leiter eine vorgebbare geometrische Struktur aufweist, dadurch gelöst, dass das Substrat mindestens eine zwischen einer ersten Elektrode und mindestens einer zweiten Elektrode angeordnete elektroaktive Schicht aufweist und der elektrisch leitfähige Leiter an dem Substrat angebracht ist, derart, dass die geometrische Struktur des elektrisch leitfähigen Leiters in Abhängigkeit eines zwischen der ersten Elektrode und der zweiten Elektrode anlegbaren elektrischen Steuersignals änderbar ist.

Im Gegensatz zum Stand der Technik wird gemäß der Lehre der Erfindung eine Änderung von mindestens einem Leiterparameter dadurch ermöglicht, dass die geometrische Struktur, insbesondere mindestens ein geometrischen Parameter des Leiters in Abhängigkeit eines elektrischen Steuersignals änderbar ist. Insbesondere wird eine einstellbare Leiteranordnung mit mindestens einem einstellbaren Leiter zur Verfügung gestellt.

Vorzugsweise wird ein Substrat mit einer elektroaktiven Schicht und mindestens zwei Elektroden, welche an gegenüberliegenden Seiten der elektroaktiven Schicht angeordnet sein können, bereitgestellt. Die beiden Elektroden bilden insbesondere eine Elektrode und eine Gegenelektrode, welche mit dem zwischen beiden Elektroden befindlichen Medium in Wechselwirkung stehen. Bei dem Medium handelt es sich vorliegend um eine elektroaktive Schicht. Unter einer elektroaktiven Schicht ist insbesondere eine Schicht zu verstehen, die unter Einwirkung eines an den Elektroden anliegenden elektrischen Steuersignals die Form ändert. Insbesondere ist die elektroaktive Schicht eine Aktuatorschicht, die beispielsweise in Abhängigkeit eines an den mindestens zwei Elektroden anliegenden veränderbaren Spannungssignals die Form, beispielsweise das Volumen ändert.

Eine Elektrode kann als eine elektrisch leitfähige Schicht ausgebildet sein, welche (voll-)flächig mit der elektroaktiven Schicht verbunden sein kann. Es versteht sich, dass die Unterseite bzw. die Oberseite der elektroaktiven Schicht auch nur teilweise mit einer elektrisch leitfähigen Schicht beschichtet sein kann.

Vorzugsweise kann eine elektrisch leitfähige Schicht aus einem Material gebildet sein, das ausgewählt ist aus der Gruppe umfassend Metalle, Metalllegierungen, leitfähige Oligo- oder Polymere, leitfähige Oxide und/oder mit leitfähigen Füllstoffen gefüllte Polymere.

Mit diesem Substrat ist erfindungsgemäß der mindestens eine elektrisch leitfähige Leiter derart verbunden, dass eine Formänderung des Substrats eine entsprechende Formänderung des Leiters bewirken kann. Beispielsweise kann der Leiter aus einem dehnfähigen Material gebildet sein, welches sich einer Dehnung bzw. Kontrahierung des Substrats anpasst. Der Leiter kann zum Beispiel wellenförmig gestaltet sein, so dass beispielsweise eine Dehnung des Substrats zu einer Verlängerung der Wellenlänge bei gleichzeitig geringerer Wellenamplitude führt, ohne dass das Material des Leiters selbst übermäßig bzw. überhaupt gedehnt wird. Beispielsweise kann das Substrat mit einem elektrisch leitfähigen Material zur Bildung des Leiters beschichtet sein. In Abhängigkeit des elektrischen Steuersignals kann die Form des Substrats und entsprechend die geometrische Struktur des Leiters geändert werden.

Der Leiter kann grundsätzlich eine beliebige zwei- oder dreidimensionale geometrische Struktur aufweisen, wobei mindestens ein geometrischer Parameter dieser zwei- oder dreidimensionalen geometrischen Struktur änderbar ist. Die geometrische Struktur des Leiters kann entsprechend einer späteren Anwendung der Leiteranordnung vorgegeben werden. Insbesondere ist erfindungsgemäß mindestens eine Leitereigenschaften zwischen einem ersten und einen zweiten Grenzwert vorzugsweise kontinuierlich einstellbar.

Der elektrisch leitfähige Leiter ist als ein separates Element gebildet und kann beispielsweise einen oder mehrere Anschlusskontakte aufweisen. Über die Anschlusskontakte kann beispielsweise ein elektrisches Signal, wie ein Datensignal, ein- oder ausgekoppelt werden. Ferner versteht es sich, dass auch jede Elektrode Anschlusskontakte aufweisen kann, um das Steuersignal anlegen zu können. Die Elektroden sind hierbei (ausschließlich) als Mittel vorgesehen, um die Form der elektroaktiven Schicht mittels eines änderbaren Steuersignals ändern zu können.

Es versteht sich, dass das Substrat auch zwei oder mehr elektroaktive Schichten mit einer entsprechenden Anzahl an Elektroden aufweisen kann. Hierdurch kann beispielsweise der einstellbare Bereich der mindestens einen Leitereigenschaft vergrößert werden. Es versteht sich ferner, dass die Leiteranordnung auch zwei oder mehr elektrisch leitfähige Leiter aufweisen kann, welche miteinander verbindbar oder verbunden sein können.

Gemäß einer ersten Ausführungsform der erfindungsgemäßen Leiteranordnung kann die elektroaktive Schicht eine dielektrische Elastomerschicht sein. Eine dielektrische Elastomerschicht weist vorzugsweise eine relativ hohe Dielektrizitätszahl auf. Darüber hinaus weist eine dielektrische Elastomerschicht vorzugsweise eine niedrige mechanische Steifigkeit auf. Diese Eigenschaften führen zu möglichen Dehnungswerten von bis zu ca. 300 %. Ferner weist eine dielektrische Elastomerschicht eine gute Einstellbarkeit, also eine definierte Änderung der Form der dielektrischen Elastomerschicht in Abhängigkeit eines elektrischen Steuersignals. Eine dielektrische Elastomerschicht ist insbesondere für eine Aktoranwendung geeignet. Es versteht sich, dass auch andere elektroaktive Schichten einsetzbar sind, wie beispielsweise Piezoschichten oder dergleichen.

Ferner kann die dielektrische Elastomerschicht gemäß einer bevorzugten Ausführungsform der Erfindung ein Material umfassen, das beispielsweise ausgewählt ist aus der Gruppe umfassend Polyurethan-Elastomere, Silikon-Elastomere und/oder Acrylat-Elastomere.

Grundsätzlich kann eine Elektrode vollflächig mit der elektroaktiven Schicht verbunden sein. Beispielsweise kann die elektroaktive Schicht entsprechend beschichtet sein. Gemäß einer weiteren Ausführungsform der Leiteranordnung gemäß der Erfindung kann mindestens eine Elektrode eine strukturierte Elektrode sein. Unter einer strukturierten Elektrode ist insbesondere eine elektrisch leitfähige Schicht zu verstehen, welche aktive und passive Bereiche aufweist. Es können gezielt bestimmte Bereich aktiviert und andere Bereiche nicht aktiviert werden. Eine gezielte Formänderung des Substrats in eine oder mehrere Richtungen ohne eine wesentliche Änderung in eine andere Richtung ist möglich.

Es versteht sich, dass gemäß weiteren Varianten der Erfindung die elektroaktive Schicht mit weiteren strukturierten Elektroden beschichtet sein kann, um gezielt unterschiedliche Bereich der elektroaktiven Schicht mit unterschiedlichen elektrischen Steuersignalen, wie beispielsweise Stromoder Spannungssignalen, zu beaufschlagen und entsprechend eine gezielte Formänderung (nur) in bestimmten Bereichen zu erhalten. Beispielsweise können mehrere Leiter, welche unmittelbar miteinander verbunden sein können, unterschiedlich geändert werden.

Wie bereits beschrieben wurde, können der mindestens eine elektrisch leitfähige Leiter und die Elektrode als separate Elemente ausgebildet sein. Der mindestens eine elektrisch leitfähige Leiter kann gemäß einer Ausführungsform zumindest teilweise in die elektroaktive Schicht eingebettet sein. Eine Einbettung bringt den Vorteil mit sich, dass eine gute Verbindung zwischen der elektroaktiven Schicht und dem Leiter hergestellt werden kann. Entsprechend exakt kann durch eine Formänderung der elektroaktiven Schicht eine entsprechende Formänderung des Leiters erzielt werden.

Alternativ kann gemäß einer weiteren Ausführungsform die elektroaktive Schicht oder eine Elektrode mit dem elektrisch leitfähigen Leiter beschichtet sein. Hierdurch kann in besonders einfacher Weise eine Leiteranordnung hergestellt werden.

In einer weiteren Ausführungsform kann der elektrisch leitfähige Leiter aus einem anderen Material als eine Elektrode gebildet sein. Insbesondere kann für den elektrisch leitfähige Leiter ein elektrisch leitfähiges Material in Abhängigkeit der Anwendung der Leiteranordnung gewählt

Des Weiteren kann gemäß einer weiteren Ausführungsform der erfindungsgemäßen Leiteranordnung vorgesehen sein, dass die Leitfähigkeit des elektrisch leitfähigen Leiters zumindest größer als die Leitfähigkeit einer Elektrode ist. Beispielsweise können unterschiedliche Materialien mit einer unterschiedlichen Leitfähigkeit für die Elektroden und den mindestens einen Leiter verwendet werden.

Ferner kann gemäß einer weiteren Ausführungsform eine Isolationsschicht zwischen dem elektrisch leitfähigen Leiter und einer Elektrode angeordnet sein. Durch eine Isolationsschicht ist in einfacher Weise eine separate Ansteuerung der Elektrode und des elektrisch leitfähigen Leiters möglich. Auch kann ein Übersprechen ("crosstalk") zwischen dem Signal zur Ansteuerung der Elektrode und dem Empfangssignal der Antenne minimiert werden, so dass eine wirksame Signalentkopplung möglich ist.

Wie bereits beschrieben wurde, kann zumindest der elektrisch leitfähige Leiter nachgiebig ausgebildet sein. Bevorzugt können auch eine Elektrode und/oder eine Isolationsschicht nachgiebig gebildet sein. In einfacher Weise kann eine Formänderung der elektroaktiven Schicht auf den mindestens einen Leiter übertragen werden, auch wenn weitere Zwischenschichten, wie beispielsweise die Isolationsschicht und/oder eine Elektrode, angeordnet sind.

Gemäß einer weiteren Ausführungsform der erfindungsgemäßen Leiteranordnung kann der elektrisch leitfähige Leiter ein Streifenleiter und/oder eine Antenne sein. Eine Streifenleiteranordnung kann beispielsweise dazu dienen, den Stromfluss durch den Streifenleiter durch eine Änderung der geometrischen Struktur des Streifenleiters zu ändern. Eine Antenne kann beispielsweise eine planare oder dreidimensionale Antenne, wie eine Parabolantenne sein. Hierbei kann mindestens eine von der geometrischen Struktur der Antenne abhängige Antenneneigenschaften, wie die Sende- oder Empfangsfrequenz, die Güte, und/oder die Polarisation, geändert werden, indem die geometrische Struktur, insbesondere mindestens ein geometrischer Parameter des mindestens einen Leiters entsprechend geändert wird.

Ein weiterer Aspekt der Erfindung ist eine Vorrichtung umfassend mindestens eine zuvor beschriebene Leiteranordnung, mindestens eine mit der Leiteranordnung verbindbare Energieversorgung und eine Steuereinrichtung konfiguriert zum Steuern der Energieversorgung, derart, dass die geometrische Struktur des elektrisch leitfähigen Leiters in Abhängigkeit eines zwischen der ersten Elektrode und der zweiten Elektrode anlegbaren elektrischen Steuersignals änderbar ist.

Insbesondere weist die Vorrichtung gemäß der Erfindung eine Steuereinrichtung auf, welche dazu konfiguriert ist, mindestens eine Leitereigenschaft durch eine Änderung der geometrischen Struktur des Leiters, also eine Änderung von mindestens einem geometrischen Parameter des Leiters, gezielt zu verändern. Beispielsweise kann eine gewünschte Leitereigenschaft vorgegeben werden. Die Steuerung kann mit Hilfe einer gespeicherten Tabelle oder durch eine Berechnung aus der vorgegebenen Leitereigenschaft einen optimalen Wert für das elektrische Steuersignal, wie einen optimalen Spannungswert, bestimmen. Ferner kann die Steuereinrichtung die mindestens eine Energieversorgung, wie eine Energiequelle, entsprechend steuern. Die Energieversorgung erzeugt dann ein entsprechendes elektrisches Steuersignal und beaufschlagt die mindestens zwei Elektroden der Leiteranordnung mit diesem Steuersignal. Beispielsweise kann als Energiequelle eine Batterie oder ein Stromnetzanschluss eingesetzt werden.

In einfacher Weise ermöglicht die Vorrichtung gemäß der Erfindung eine Änderung von mindestens einer Leitereigenschaft der Leiteranordnung.

Ein weiterer Aspekt der Erfindung ist ein Kommunikationsgerät umfassend die zuvor beschriebene Vorrichtung. Beispielsweise umfasst ein Radio Frequency Identification (RFID) Transponder die zuvor beschriebene Vorrichtung. Bei der Leiteranordnung der Vorrichtung kann es sich beispielsweise um eine Antennenanordnung handeln, welche in einem RFID-Transponder zum Senden und Empfangen von elektromagnetischen Wellen eingesetzt werden kann. Beispielsweise kann es sich um eine steuerbare Dipolantenne, Spiralantenne, Vivaldiantenne, etc. handeln.

Ein noch weiterer Aspekt der Erfindung ist ein Verfahren zur Herstellung einer Leiteranordnung, insbesondere einer zuvor beschriebenen Leiteranordnung, umfassend Bereitstellen eines Substrats mit mindestens einer zwischen einer ersten Elektrode und mindestens einer zweiten Elektrode angeordneten elektroaktiven Schicht, Bereitstellen mindestens eines elektrisch leitfähigen Leiters mit einer vorgebbaren geometrischen Struktur und Anbringen des elektrisch leitfähigen Leiters an dem Substrat, derart, dass die geometrische Struktur des elektrisch leitfähigen Leiters in Abhängigkeit eines zwischen der ersten Elektrode und der zweiten Elektrode anlegbaren elektrischen Steuersignals änderbar ist. In einfacher Weise kann eine Leiteranordnung geschaffen werden, die eine Veränderung mindestens einer Leitereigenschaft ermöglicht.

Gemäß einer ersten Ausführungsform des erfindungsgemäßen Verfahrens kann das Substrat mit dem elektrisch leitfähigen Leiter bedruckt werden. Beispielsweise kann der elektrisch leitfähige Leiter auf die elektroaktive Schicht oder auf eine Elektrode aufgedruckt werden. Es versteht sich, dass das Substrat weitere Schichten, wie beispielsweise eine Isolationsschicht aufweisen kann. Dann kann der Leiter auch auf die Isolationsschicht aufgedruckt werden. Ein Druckverfahren kann in einfacher Weise durchgeführt werden. Insbesondere ist eine Massenproduktion einer Leiteranordnung mit einer erhöhten Produktionsrate möglich.

Ferner kann gemäß einer weiteren Ausführungsform des Verfahrens gemäß der Erfindung die elektroaktive Schicht mit der ersten Elektrode und/oder der zweiten Elektrode strukturiert beschichtet werden. Bevorzugt kann die elektroaktive Schicht beidseitig mit jeweils einer leitfähigen Schicht beschichtet, beispielsweise strukturiert bedruckt werden. Es versteht sich, dass auch drei oder mehr Elektroden in entsprechender Weise angeordnet werden können.

Weiterhin ist es möglich, neben dem elektrisch leitfähigen Leiter weitere, insbesondere passive, elektrische Bauelemente, wie beispielsweise Spulen und/oder Kondensatoren, auf das Substrat aufzudrucken oder in einer anderen geeigneten Weise auf dem Substrat anzubringen, um bestimmte zusätzliche Eigenschaften oder Funktionalitäten zu integrieren bzw. bestehende zu optimieren.

Es gibt nun eine Vielzahl von Möglichkeiten, die erfindungsgemäßen Leiteranordnung, die erfindungsgemäße Vorrichtung, den erfindungsgemäßen RFID Transponder und das erfindungsgemäße Verfahren zur Herstellung einer Leiteranordnung auszugestalten und weiterzuentwickeln. Hierzu sei einerseits verwiesen auf die den unabhängigen Patentansprüchen nachgeordneten Patentansprüche, andererseits auf die Beschreibung von Ausführungsbeispielen in Verbindung mit der Zeichnung. In der Zeichnung zeigt:
- Fig. 1: eine schematische Ansicht eines ersten Ausführungsbeispiels einer Leiteranordnung gemäß der vorliegenden Erfindung;
- Fig. 2: eine schematische Ansicht eines zweiten Ausführungsbeispiels einer Leiteranordnung gemäß der vorliegenden Erfindung;
- Fig. 3: eine erste schematische Draufsicht des zweiten Ausführungsbeispiels einer Leiteranordnung in einem ersten Zustand gemäß der vorliegenden Erfindung;
- Fig. 4: eine weitere schematische Draufsicht des zweiten Ausführungsbeispiels einer Leiteranordnung in einem zweiten Zustand gemäß der vorliegenden Erfindung;
- Fig. 5: eine schematische Ansicht eines Ausführungsbeispiels einer Vorrichtung gemäß der vorliegenden Erfindung; und
- Fig. 6: ein Flussdiagramm eines Ausführungsbeispiels eines Verfahrens gemäß der vorliegenden Erfindung.

Nachfolgend werden in den Figuren gleiche Bezugszeichen für gleiche Elemente verwendet.

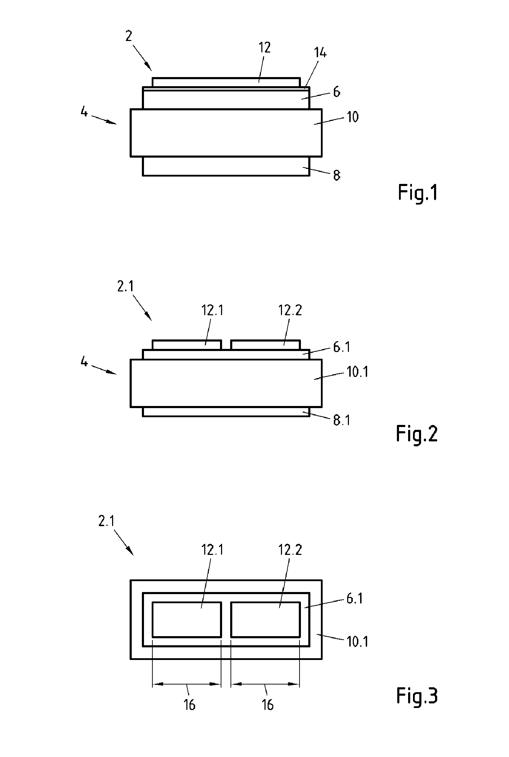

Figur 1 zeigt eine schematische Ansicht eines ersten Ausführungsbeispiels einer Leiteranordnung 2 gemäß der vorliegenden Erfindung. Die dargestellte Leiteranordnung 2 umfasst ein Substrat 4. Das Substrat 4 weist eine erste obere Elektrode 6 und eine zweite untere Elektrode 8 auf. Eine Elektrode 6, 8 kann vorzugsweise aus einem Material gebildet sein, das ausgewählt ist aus der Gruppe umfassend Metalle, Metalllegierungen, leitfähige Oligo- oder Polymere, leitfähige Oxide und/oder mit leitfähigen Füllstoffen gefüllte Polymere.

Zwischen der ersten Elektrode 6 und der zweiten Elektrode 8 kann eine elektroaktive Schicht 10, insbesondere eine dielektrische Elastomerschicht 10, angeordnet sein. Eine dielektrische Elastomerschicht 10, wie eine dielektrische Elastomerfolie, weist vorzugsweise eine relativ hohe Dielektrizitätszahl auf. Darüber hinaus weist eine dielektrische Elastomerschicht 10 vorzugsweise eine niedrige mechanische Steifigkeit auf. Dies führt zu möglichen Dehnungswerten von bis zu ca. 300 %. Eine dielektrische Elastomerschicht 10 kann insbesondere für eine Aktoranwendung eingesetzt werden.

Darüber hinaus kann eine Elektrode 6, 8 als elektrisch leitende Schicht ausgebildet sein. Eine Elektrode 6, 8 kann bevorzugt flächig mit der dielektrischen Elastomerschicht 10 verbunden sein. Beispielsweise kann eine Elektrode 6, 8 vollflächig mit der dielektrischen Elastomerschicht 10 beschichtet sein. Neben der vollflächigen Beschichtung kann die dielektrischen Elastomerschicht 10 auch nur teilweise mit einer elektrisch leitfähigen Schicht 6 bzw. 8 beschichtet sein. Mit anderen Worten kann eine strukturierte bzw. segmentierte Elektrode 6, 8 erzeugt werden. Insbesondere können hierdurch aktive und passive Bereiche geschaffen werden.

Ferner weist die Leiteranordnung 2 mindestens einen elektrisch leitfähigen Leiter 12 mit einer bestimmten geometrischen Struktur auf. Wie zu erkennen ist, ist der Leiter 12 im vorliegenden Ausführungsbeispiel auf einer Schicht 14 angebracht. Bei der Schicht 14 kann es sich bevorzugt um eine geeignete elektrische Isolationsschicht 14 handeln. Der Leiter 12 kann aus dem gleichen Material wie die Elektrode 6 oder aus einem anderen Material sein.

Es versteht sich hierbei, dass ein elektrisch leitfähiger Leiter 12 grundsätzlich eine beliebige vorgebbare geometrische Struktur aufweisen kann. Unter einer geometrischen Struktur ist insbesondere eine zwei- oder dreidimensionale Form zu verstehen, die beliebig sein kann. Insbesondere kann die geometrische Struktur in Abhängigkeit einer Anwendung der Leiteranordnung 2 gewählt werden. Beispielsweise kann der Leiter 12 einen rechteckförmigen Querschnitt mit einer bestimmten Länge und einem bestimmten Verlauf aufweisen. Es versteht sich, dass ein Leiter 12 auch eine beliebig andere geometrische Struktur haben kann.

Die Elektrode 6, 8 und/oder der Leiter 12 und/oder die Isolationsschicht 14 sind bevorzugt dehnfähig bzw. nachgiebig ausgebildet. Die Nachgiebigkeit führt dazu, dass eine Formänderung der elektroaktiven Schicht 10 nicht behindert wird und insbesondere sich die Elektrode 6, 8, die Isolationsschicht 14 und/oder der Leiter 12 entsprechend der Formänderung der elektroaktiven Schicht 10 ändern können. Mit anderen Worten kann eine Formänderung der elektroaktiven Schicht 10 zumindest eine entsprechende Formänderung des Leiters 12 bewirken. Um eine nachgiebige Schicht zu erhalten, kann ein entsprechend dehnfähiges Material eingesetzt werden. Alternativ oder zusätzlich kann die Form einer Schicht beispielsweise wellenförmig ausgebildet werden. Insbesondere bei metallischen Schichten kann durch ein wellenförmiges Design eine Dehnfähigkeit bzw. Nachgiebigkeit erzielt werden.

Wird beispielsweise an die zwei Elektroden 6, 8 ein elektrisches Steuersignal angelegt, wie eine elektrische Spannung, bildet sich zwischen den Elektroden 6, 8 ein elektrisches Feld. Dieses elektrische Feld bewirkt eine Formänderung, insbesondere Volumenänderung der dielektrischen Elastomerschicht 10. Die Formänderung der dielektrischen Elastomerschicht 10 hängt insbesondere von der Feldstärke des elektrischen Feldes bzw. von der angelegten Spannung ab. Mit anderen Worten kann durch eine Änderung der elektrischen Spannung die Form entsprechend geändert werden. Es versteht sich, dass es einen unteren Grenzwert (z.B. 0 V) und einen oberen Grenzwert (Durchbruchsspannung) geben kann, die die mögliche Formänderung der dielektrischen Elastomerschicht 10 begrenzen. Bei einer Erhöhung der Spannung kann sich die Oberfläche der dielektrischen Elastomerschicht 10 erhöhen und bei einer Reduzierung der Spannung kann sich die Oberfläche der dielektrischen Elastomerschicht 10 entsprechend verringern.

Ferner kann die Formänderung von der Struktur der ersten und/oder der zweiten Elektrode 6, 8 abhängen. Wie ausgeführt wurde, können durch eine strukturierte Elektrode 6, 8 aktive und passive Bereiche geschaffen werden. Durch die Ausbildung von aktiven und passiven Bereichen kann die Formänderung der elektroaktiven Schicht 10 gezielt beeinflusst werden. Insbesondere kann hierdurch eine Formänderung in eine oder mehrere Richtungen zumindest verstärkt und in eine oder mehrere andere Richtungen zumindest reduziert werden.

Die Formänderung der dielektrischen Elastomerschicht 10 wiederum bewirkt zumindest eine Formänderung des mindestens einen elektrisch leitfähigen Leiters 12. Mit anderen Worten kann die geometrische (Grund-)Struktur bzw. Form des Leiters 12 gezielt in Abhängigkeit des elektrischen Steuersignals, wie einer Spannung, geändert bzw. angepasst werden. Durch eine Änderung der geometrischen Struktur kann mindestens eine Eigenschaft des Leiters 12 geändert bzw. angepasst werden.

Ist der Leiter 12 beispielsweise Teil einer Antenne oder die Antenne selbst, kann gezielt mindestens ein Antennenparameter durch eine Änderung der geometrischen Struktur des Leiters 12 geändert werden. Unter einer Änderung der geometrischen Struktur des elektrischen Leiters 12 ist insbesondere eine gezielte Änderung mindestens eines geometrischen Parameters zu verstehen. Beispielhafte geometrische Parameter eines Leiters 12 sind die Länge des Leiters 12, die Breite des Leiters 12, die Höhe des Leiters 12, der Querschnitt des Leiters 12 und/oder die Verlaufsform, wie beispielsweise eine Krümmung des Leiters 12. Es versteht sich, dass eine Mehrzahl dieser geometrischen Parameter gleichzeitig durch Anlegen eines Spannungssignals geändert werden kann. Wenn es sich um eine Antenne handelt, dann kann durch eine gezielte Änderung eines oder mehrere geometrischer Parameter ein oder mehrere Antennenparameter, wie die Sendefrequenz, Empfangsfrequenz, Polarisation und/oder die Güte, eingestellt werden.

Figur 2 zeigt eine weitere schematische Ansicht eines zweiten Ausführungsbeispiels einer Leiteranordnung 2.1 gemäß der vorliegenden Erfindung. Die Leiteranordnung 2.1 weist ein Substrat 4.1 auf. Das Substrat 4.1 umfasst eine zwischen einer ersten Elektrode 6.1 und einer zweiten Elektrode 8.1 angeordnete elektroaktive Schicht 10.1, wie eine dielektrische Elastomerschicht 10.1.

Im Unterschied zur Leiteranordnung 2 gemäß der Figur 1 umfasst die Leiteranordnung 2.1 gemäß der Figur 2 einen ersten elektrisch leitfähigen Leiter 12.1 und einen zweiten elektrisch leitfähigen Leiter 12.2. Beispielsweise bilden die Leiter 12.1 und 12.2 eine Antennenstruktur, wie eine Dipolantenne mit geteilten Leitern 12.1 und 12.2. Zwischen den Leitern 12.1 und 12.2 könnte beispielsweise ein Anpassungsnetzwerk angeordnet werden, um ein Steuersignal ein- bzw. auszukoppeln. Hierbei kann ein Leiter 12.1, 12.2 als geometrische Struktur einen im Wesentlichen rechteckförmigen Querschnitt mit einer vorgebbaren Länge aufweisen. Jeder Leiter 12.1, 12.2 ist bevorzugt als separates Element ausgebildet.

Darüber hinaus kann der Figur 2 entnommen werden, dass im Vergleich zur Figur 1 die Leiter 12.1 und 12.2 auf der Elektrode 6.1 aufgebracht sind. Beispielsweise kann die Elektrode 6.1 zur Bildung der Leiter 12.1 und 12.2 mit einem elektrisch leitfähigen Material beschichtet sein. Zur Aufbringung des elektrisch leitfähigen Materials eignen sich insbesondere Druckverfahren. Vorzugsweise kann das Material zur Bildung der Leiter 12.1 und 12.2 im Vergleich zum Material der Elektrode 6.1 eine höhere Leitfähigkeit aufweisen.

Es versteht sich, dass gemäß anderen Varianten der vorliegenden Erfindung die Leiteranordnung 2.1 auch weitere Schichten aufweisen kann. Neben mehreren elektroaktiven Schichten, wobei bei mehreren elektroaktiven Schichten bevorzugt zwischen sämtlichen benachbarten Schichten zumindest teilweise elektrische leitenfähige Schichten vorgesehen sein können, können auch elektrisch nichtleitfähige Schichten vorgesehen sein. Ferner können auch drei oder mehr elektrisch leitfähige Leiter vorgesehen sein.

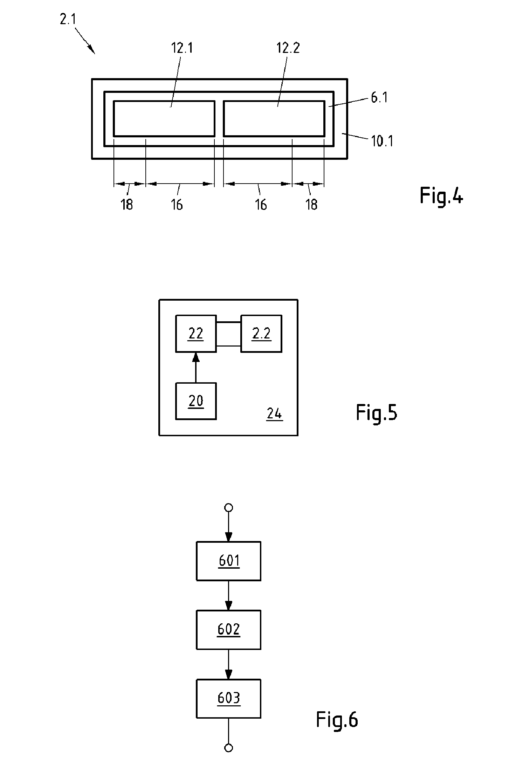

Nachfolgend wird anhand der Figuren 3 und 4 eine beispielhafte Anwendungsmöglichkeit einer erfindungsgemäßen Leiteranordnung beschrieben.

In der Figur 3 ist eine erste schematische Draufsicht des zweiten Ausführungsbeispiels der Leiteranordnung 2.1 gemäß Figur 2 in einem ersten Zustand dargestellt. Bei dem ersten Zustand kann es sich beispielsweise um einen Grundzustand bzw. Ausgangszustand handeln. Hierbei kann die geometrische Struktur der zwei Leiter 12.1 und 12.2 einer vorgebbaren geometrischen Grundstruktur entsprechen. In diesem Grundzustand kann an den Elektroden 6.1 und 8.1 beispielsweise kein elektrisches Steuersignal anliegen, wie beispielsweise eine Spannung von 0 V. Es versteht sich, dass auch andere Spannungswerte als Grundwert denkbar sind.

Wie bereits ausgeführt wurde, können die Leiter 12.1 und 12.2 eine geteilte Dipolantenne bilden. Bei einer derartigen Antenne hängt die optimale Sende- oder Empfangsfrequenz insbesondere von dem Wert 16 der Länge der vorliegend rechteckförmigen Leiter 12.1 und 12.2 ab. Mit anderen Worten kann im Allgemeinen die Sende- und/oder Empfangsfrequenz bei der Leiteranordnung 2.1 geändert werden, indem die geometrische Form der Leiter 12.1 und 12.2 geändert wird. Wie nachfolgend mit Hilfe der Figur 4 beschrieben wird, wird eine Formänderung insbesondere durch eine Änderung des an den zwei Elektroden 6.1 und 8.1 anliegenden elektrischen Steuersignals erzielt.

Figur 4 zeigt eine weitere schematische Draufsicht des zweiten Ausführungsbeispiels der Leiteranordnung 2.1 gemäß Figur 3 in einem zweiten Zustand. Im Vergleich zum Ausführungsbeispiel gemäß Figur 3 hat sich die Oberfläche der Leiteranordnung 2.1 in Figur 1 vergrößert und die Dicke verringert (nicht gezeigt).

Die Formänderung hängt insbesondere von einem an den Elektroden 6.1, 8.1 im zweiten Zustand im Vergleich zum ersten Zustand anderen anliegenden elektrischen Steuersignal, wie einer anderen Spannung, beispielsweise einer höheren Spannung, ab.

Wie in Figur 4 zu erkennen ist, bewirkt eine Spannungsänderung von einem ersten auf einen zweiten Spannungswert eine Formänderung der Leiteranordnung 2.1. Eine Spannungsänderung bewirkt insbesondere eine Volumenänderung der elektroaktiven Schicht 10.1. Im vorliegenden beispielhaften Fall wird durch eine Formänderung im Wesentlichen die Länge der Leiteranordnung 2.1 geändert, während die Breite der Leiteranordnung nahezu unverändert bleiben kann. Hierdurch kann die Länge der Leiter 12.1 und 12.2 jeweils um einen Wert 18 vergrößert werden.

Eine Längenänderung der Leiteranordnung 2.1 kann insbesondere durch eine entsprechend strukturierte erste und/oder zweite Elektrode 6.1 und 8.1 erzielt werden. Es können bei einer strukturierten Elektrode 6.1, 8.1 gezielt aktive und passive Bereiche geschaffen werden, um gezielt eine Formänderung eines Leiters 12.1, 12.2 in mindestens eine Richtung zu verstärken und in eine andere Richtung zu reduzieren. Es versteht sich, dass grundsätzlich jede beliebige Formänderung, insbesondere auch eine dreidimensionale Änderung, durch geeignet strukturierte Elektroden 6.1, 8.1 und/oder Spannungsänderungen erzielt werden kann. Ferner kann insbesondere die Grundform eines Leiters 12.1, 12.2 beliebig sein. Weitere beispielhafte Antennenbauformen sind eine Spiralantenne, eine Vivaldiantenne, etc.

Bevorzugt kann die Leiterform kontinuierlich zwischen einer Grundform bei einem minimalen Signalwert, wie beispielsweise 0 V, und einer maximalen Änderung bei einem maximalen Signalwert, wie einem maximalen Spannungswert (Durchbruchswert), eingestellt werden. Es versteht sich, dass gemäß anderen Varianten auch eine diskrete Einstellung der geometrischen Form eines Leiters vorgesehen sein kann. Unter einer diskreten Einstellung ist zu verstehen, dass beispielsweise zwei geometrische Zustände vorgegeben werden, welche (ausschließlich) eingestellt werden können.

Figur 5 zeigt eine schematische Ansicht eines Ausführungsbeispiels einer Vorrichtung 24 gemäß der vorliegenden Erfindung. Die Vorrichtung 24 weist mindestens eine Leiteranordnung 2.2 auf. Die Leiteranordnung 2.2 kann mit einer Energieversorgung 22 verbunden sein. Bei der Energieversorgung 22 kann es sich um eine Energiequelle 22, wie eine Batterie, ein Solarmodul, ein Netzanschluss oder dergleichen, handeln.

Des Weiteren ist gemäß dem vorliegenden Ausführungsbeispiel eine Steuereinrichtung 20 vorgesehen. Die Steuereinrichtung 20 kann beispielsweise einen Prozessor, Speichermittel und/oder Schnittstellen umfassen. Die Steuereinrichtung 20 ist insbesondere dazu konfiguriert, die Leiteranordnung 2.2 bzw. die Energieversorgung 22 zu steuern.

Wenn es sich bei der Leiteranordnung 2.2 beispielsweise um eine Antennenanordnung 2.2 handelt, kann mittels der Steuereinrichtung 20 mindestens ein Antennenparameter eingestellt werden. Beispielsweise kann eine gewünschte Sendefrequenz vorgegeben werden. Wie bereits beschrieben wurde, kann insbesondere die Form der geometrischen Struktur der Antenne zur Erzielung der optimalen Sendefrequenz durch Anlegen eines elektrischen Steuersignals an das Substrat angepasst werden.

Bei einem Spannungssignal kann beispielsweise aus einer in einem Speicher abgelegten Tabelle die für eine Sendefrequenz anzulegende Spannung von der Steuereinrichtung 20 ausgelesen werden. Auch ist es möglich, dass ein Prozessor aus der vorgegebenen Sendefrequenz den optimalen Spannungswert berechnet. Dann kann die Steuereinrichtung 20 die Energieversorgung 22 entsprechend ansteuern. Die Energieversorgung 22 kann dann an die Elektroden der Antennenanordnung 2.2 eine entsprechende Spannung anlegen. Es versteht sich, dass in entsprechender Weise eine Vielzahl von Parametern eines Leiters, insbesondere einer Antenne, eingestellt werden können.

Es versteht sich ferner, dass gemäß weiteren Varianten der Erfindung, die Vorrichtung 24auch zwei oder mehr Leiteranordnungen 2.2, zwei oder mehr Energieversorgungen 22 und/oder zwei oder mehr Steuereinrichtungen 20 aufweisen kann.

Die Vorrichtung 24 kann beispielsweise in einem Telekommunikationsgerät, wie einem Mobilfunkgerät oder dergleichen, eingesetzt werden, wobei die Vorrichtung 24 mit mindestens einer als Sendeantenne ausgebildeten Leiteranordnung 2.2 und/oder mindestens einer als Empfangsantenne ausgebildeten Leiteranordnung 2.2 versehen ist. Beispielsweise kann es sich um einen RFID-Transponder handeln.

Figur 6 zeigt ein Flussdiagramm eines Ausführungsbeispiels eines Verfahrens gemäß der vorliegenden Erfindung. In einem ersten Schritt 601 kann ein Substrat mit mindestens einer zwischen einer ersten Elektrode und mindestens einer zweiten Elektrode angeordneten elektroaktiven Schicht bereitgestellt werden. Beispielsweise kann eine elektroaktive Schicht, wie eine dielektrische Elastomerfolie, beidseitig mit jeweils einer leitfähigen Schicht zumindest teilweise beschichtet werden. Beispielsweise kann eine elektrische Schicht mittels eines Druckvorgangs aufgebracht werden.

In einem nächsten Schritt 602 kann mindestens ein elektrisch leitfähiger Leiter mit einer vorgebbaren geometrischen Struktur bereitgestellt werden. In einem weiteren Schritt 603 kann dann dieser elektrisch leitfähige Leiter an dem Substrat derart angebracht werden, dass die geometrische Struktur des elektrisch leitfähigen Leiters in Abhängigkeit eines zwischen der ersten Elektrode und der zweiten Elektrode anlegbaren elektrischen Steuersignals, wie ein Spannungssignal, änderbar ist. Beispielsweise kann das Substrat mit dem elektrisch leitfähigen Leiter bedruckt werden. Hierdurch kann in besonders einfacher Weise erreicht werden, dass der Leiter nachgiebig ist, sich also entsprechend der Formänderung der dielektrischen Schicht ändern kann.

Es versteht sich, dass die Reihenfolge der zuvor beschriebenen Schritte grundsätzlich beliebig sein kann. Beispielsweise kann zunächst der elektrisch leitenfähige Leiter in eine elektroaktive Schicht eingebettet werden oder eine Elektrode und ein elektrisch leitenfähiger Leiter können einstückig bereitgestellt werden.

## Patentansprüche

1. Leiteranordnung (2, 2.1, 2.2), umfassend:
mindestens einen an einem Substrat (4, 4.1) angebrachten elektrisch leitfähigen Leiter (12, 12.1, 12.2), wobei der elektrisch leitfähige Leiter (12, 12.1, 12.2) eine vorgebbare geometrische Struktur aufweist,
**dadurch gekennzeichnet,**
**dass** das Substrat (4, 4.1) mindestens eine zwischen einer ersten Elektrode (6, 6.1) und
mindestens einer zweiten Elektrode (8, 8.1) angeordnete elektroaktive Schicht (10, 10.1) aufweist, und
**dass** der elektrisch leitfähige Leiter (12, 12.1, 12.2) an dem Substrat (4, 4.1) angebracht ist, derart, dass die geometrische Struktur des elektrisch leitfähigen Leiters (12, 12.1, 12.2) in Abhängigkeit eines zwischen der ersten Elektrode (6, 6.1) und der zweiten Elektrode (8, 8.1) anlegbaren elektrischen Steuersignals änderbar ist.

2. Leiteranordnung (2, 2.1, 2.2) nach Anspruch 1, **dadurch gekennzeichnet, dass** die elektroaktive Schicht (10, 10.1) eine dielektrische Elastomerschicht (10, 10.1) ist.

3. Leiteranordnung (2, 2.1, 2.2) nach Anspruch 2, **dadurch gekennzeichnet, dass** die dielektrische Elastomerschicht (10, 10.1) ein Material umfasst, das ausgewählt ist aus der Gruppe umfassend Polyurethan-Elastomere, Silikon-Elastomere und/oder Acrylat-Elastomere.

4. Leiteranordnung (2, 2.1, 2.2) nach einem der vorherigen Ansprüche, **dadurch gekennzeichnet, dass** mindestens eine Elektrode (6, 6.1, 8, 8.1) eine strukturierte Elektrode (6, 6.1, 8, 8.1) ist.

5. Leiteranordnung (2, 2.1, 2.2) nach einem der vorherigen Ansprüche 1 bis 4, **dadurch gekennzeichnet,**
- **dass** der elektrisch leitfähige Leiter (12, 12.1, 12.2) zumindest teilweise in die elektroaktive Schicht (10, 10.1) eingebettet ist, oder
- **dass** die elektroaktive Schicht (10, 10.1) oder eine Elektrode (6, 6.1, 8, 8.1) mit dem elektrisch leitfähigen Leiter (12, 12.1, 12.2) beschichtet ist.

6. Leiteranordnung (2, 2.1, 2.2) nach einem der vorherigen Ansprüche, **dadurch gekennzeichnet, dass** die Leitfähigkeit des elektrisch leitfähigen Leiters (12, 12.1, 12.2) zumindest größer als die Leitfähigkeit einer Elektrode (6, 6.1, 8, 8.1) ist.

7. Leiteranordnung (2, 2.1, 2.2) nach einem der vorherigen Ansprüche, **dadurch gekennzeichnet, dass** elektrisch leitfähige Leiter (12, 12.1, 12.2) aus einem anderen Material als eine Elektrode (6, 6.1, 8, 8.1) gebildet ist

8. Leiteranordnung (2, 2.1, 2.2) nach einem der vorherigen Ansprüche, **dadurch gekennzeichnet, dass** eine Isolationsschicht (14) zwischen dem elektrisch leitfähigen Leiter (12, 12.1, 12.2) und einer Elektrode (6, 6.1, 8, 8.1) angeordnet ist.

9. Leiteranordnung (2, 2.1, 2.2) nach einem der vorherigen Ansprüche, **dadurch gekennzeichnet, dass** zumindest der elektrisch leitfähige Leiter (12, 12.1, 12.2) nachgiebig ausgebildet ist.

10. Leiteranordnung (2, 2.1, 2.2) nach einem der vorherigen Ansprüche, **dadurch gekennzeichnet, dass** der elektrisch leitfähige Leiter (12, 12.1, 12.2) ein Streifenleiter oder eine Antenne ist.

11. Vorrichtung (24), umfassend:
- mindestens eine Leiteranordnung (2, 2.1, 2.2) gemäß einem der vorherigen Ansprüche,
- mindestens eine mit der Leiteranordnung (2, 2.1, 2.2) verbindbare Energieversorgung (22), und
- mindestens eine Steuereinrichtung (20) konfiguriert zum Steuern der Energieversorgung (22), derart, dass die geometrische Struktur eines elektrisch leitfähigen Leiters (12, 12.1, 12.2) in Abhängigkeit eines zwischen einer ersten Elektrode (6, 6.1) und mindestens einer zweiten Elektrode (8, 8.1) anlegbaren von der Energieversorgung (22) bereitgestellten elektrischen Steuersignals änderbar ist.

12. Kommunikationsgerät umfassend die Vorrichtung (24) nach Anspruch 11.

13. Verfahren zur Herstellung einer Leiteranordnung (2, 2.1, 2.2), umfassend:
- Bereitstellen eines Substrats (4, 4.1) mit mindestens einer zwischen einer ersten Elektrode (6, 6.1) und einer zweiten Elektrode (8, 8.1) angeordneten elektroaktiven Schicht (10, 10.1),
- Bereitstellen mindestens eines elektrisch leitfähigen Leiters (12, 12.1, 12.2) mit einer vorgebbaren geometrischen Struktur, und
- Anbringen des elektrisch leitfähigen Leiters (12, 12.1, 12.2) an dem Substrat (4, 4.1), derart, dass die geometrische Struktur des elektrisch leitfähigen Leiters (12, 12.1, 12.2) in Abhängigkeit eines zwischen der ersten Elektrode (6, 6.1) und der zweiten Elektrode (8, 8.1) anlegbaren elektrischen Steuersignals änderbar ist.

14. Verfahren nach Anspruch 13, **dadurch gekennzeichnet, dass** das Substrat (4, 4.1) mit dem elektrisch leitfähigen Leiter (12, 12.1, 12.2) bedruckt wird.

15. Verfahren nach Anspruch 13 oder 14, **dadurch gekennzeichnet, dass** die elektroaktive Schicht (10, 10.1) mit der ersten Elektrode (6, 6.1) und/oder der zweiten Elektrode (8, 8.1) strukturiert beschichtet wird.
